(19) Europäisches Patentamt
European Patent Office
Office européen des brevets

(11) **EP 4 192 208 A1**

(12) **EUROPEAN PATENT APPLICATION**
published in accordance with Art. 153(4) EPC

(43) Date of publication:
**07.06.2023 Bulletin 2023/23**

(21) Application number: **21861963.3**

(22) Date of filing: **18.08.2021**

(51) International Patent Classification (IPC):
**H05K 3/00** (2006.01)    **H05K 3/28** (2006.01)
**H05K 1/02** (2006.01)

(52) Cooperative Patent Classification (CPC):
**H05K 1/02; H05K 3/00; H05K 3/28**

(86) International application number:
**PCT/KR2021/010948**

(87) International publication number:
**WO 2022/045666 (03.03.2022 Gazette 2022/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.08.2020 KR 20200110179**

(71) Applicant: **Doosan Corporation**
**Seoul 04563 (KR)**

(72) Inventors:
• **RYU, Euidock**
  **Yongin-si, Gyeonggi-do 16858 (KR)**
• **KIM, Sungmoon**
  **Yongin-si, Gyeonggi-do 16858 (KR)**
• **KIM, Jinwoo**
  **Yongin-si, Gyeonggi-do 16858 (KR)**
• **PARK, Subyung**
  **Yongin-si, Gyeonggi-do 16858 (KR)**
• **CHAE, Dongho**
  **Yongin-si, Gyeonggi-do 16858 (KR)**

(74) Representative: **Isarpatent**
**Patent- und Rechtsanwälte Barth**
**Charles Hassa Peckmann & Partner mbB**
**Friedrichstrasse 31**
**80801 München (DE)**

(54) **METHOD FOR MANUFACTURING FLEXIBLE PRINTED CIRCUIT BOARD AND FLEXIBLE PRINTED CIRCUIT BOARD MANUFACTURED BY SAME**

(57)    The present invention relates to a method for manufacturing a double access flexible printed circuit board, having excellent mass production and cost-reduction effects by a roll-to-roll (R2R) process throughout the entire process, and a double access flexible printed circuit board manufactured by the method.

[Fig. 1]

EP 4 192 208 A1

## Description

## Technical Field

The disclosure relates to a method for manufacturing a flexible printed circuit board and a flexible printed circuit board manufactured by the method and, particularly, to a method for manufacturing a double access-type flexible printed circuit board, having excellent mass productivity and cost reduction effect by a roll-to-roll (R2R) process throughout the entire process, and a double access-type flexible printed circuit board manufactured by the method.

## Background Art

A double access-type flexible printed circuit board (FPCB) includes a circuit pattern formed on a copper foil itself and is configured by attaching a coverlay having a plurality of openings to one surface of a copper foil to form a circuit pattern and then attaching a coverlay having a plurality of openings to the other surface of the copper foil such that the circuit pattern can be accessed from both surfaces through the openings of the coverlays.
The double access-type flexible printed circuit board may generally be manufactured by the following method.
For example, a first coverlay film that is punched out to have a plurality of punched parts is laminated to the lower part(lower surface) of a copper foil by a hot press machine, and then a guide hole for alignment between layers during exposure is formed in the copper foil. Thereafter, a dry film is placed on the outer surface of the copper foil and a carrier film is placed on the outer surface of the first coverlay film, followed by performing exposure, development, and etching. The dry film is exfoliated and removed, and then the carrier film is removed. Subsequently, a punched second coverlay film is laminated on the outer surface of the copper foil by a hot press machine to manufacture a flexible printed circuit board.
A conventional flexible printed circuit board is manufactured in the form of a panel. In manufacturing a flexible printed circuit board in the form of a panel, a press process using surface pressure is employed during lamination. At this time, fine voids are generated at the interface formed by laminating a metal panel and a coverlay film due to the surface-to-surface lamination. However, there is difficulty in removing the voids through surface pressure pressing performed for a long time. Even after voids are removed through surface pressure pressing performed for a long time, poor elasticity may occur due to the different dimensional change rate between the film and the metal circuit.
In addition, in manufacturing a conventional flexible printed circuit board, a problem associated with the alignment may occur during laminating of the metal foil and the coverlay film during the process. Therefore, in order to increase the matching degree, the conventional process has been performed manually. However, when moving and handling a product through the manual process, defects such as wrinkles and contamination inevitably occurred in the product. Wrinkles and contamination of products caused by the recent trend of large-area products (500x500mm → 500x1000mm or more) to increase product productivity have increased the defect rate and acted as major hurdles such as decreasing productivity and yield and increasing manpower.
In addition, the manufacturing process of the conventional flexible printed circuit board required a guide hole punching process for forming a separate guide hole in the metal foil in order to align the punched part of the first coverlay film and the metal circuit during an exposure process. For example, in the guide hole punching process, after laminating a first coverlay film having a plurality of punched parts (here, the punched parts include guide holes) to a metal foil, a guide hole is formed through punching at the position of the metal foil corresponding the punched part which is the guide hole of the first coverlay film. When the process of forming a guide hole in the metal foil through punching in accordance with the guide hole in the first coverlay film is added, cost arises due to the additional process and the manufacturing time is increased. In addition, burrs occur during the process of forming the guide hole in the metal foil through punching, and the burrs cause foreign substance defects.
In addition, in the related art, when a circuit is implemented on a metal foil, a dry film is attached onto the metal foil and a carrier film is attached onto a first coverlay film. The carrier film is used to prevent an etchant from penetrating into a punched part of the first coverlay film. However, the etchant may penetrate between the punched part of the first coverlay film and the carrier film, resulting in circuit defects. In addition, after manufacturing a product, adhesive (ADH) residue remains when the carrier film is removed, and thus an additional process for removing the residue is required. In addition, in the related art, in order to prevent the penetration of the etchant, a separate chemical was treated to prevent the penetration of the etchant into the punched part of the first coverlay film, before attaching the carrier film. As a result, an additional process cost arises and the manufacturing time also further increased, causing lower productivity.

## Disclosure of Invention

### Technical Problem

The disclosure is to provide a method for manufacturing a large-area flexible printed circuit board having with excellent quality, mass productivity, and cost reduction effects through roll-to-roll (R2R) throughout the entire process, and a flexible printed circuit board manufactured thereby.

### Solution to Problem

In view of the foregoing, the disclosure provides a method for manufacturing a flexible printed circuit board by a roll-to-roll continuous manufacturing method. According to an example, the method includes: (S100) forming one or a plurality of first holes and a plurality of first recognition marks in a first coverlay film continuously supplied from a first coverlay supply roller around which the first coverlay film is wound; (S200) forming a first laminate by laminating a metal foil continuously supplied from a metal foil supply roller around which the metal foil is wound on a first surface of the first coverlay film of the (S100) step; and (S300) forming a second laminate by laminating a first dry film and a second dry film continuously supplied from a first and second dry film supply roller on a first surface and a second surface of the first laminate, respectively, wherein the width of the first coverlay film is wider than that of the metal foil, and the plurality of first recognition marks of the (S100) step are formed in an area of the first coverlay film that does not overlap with the metal foil.

The above method does not include, after the (S200) step and before the (S300) step, forming an identification mark for alignment during exposure in the metal foil of the first laminate.

In the (S200) step, the first coverlay film may be line-laminated on the metal foil by using a pair of first heating rollers facing both surfaces of the first laminate, respectively.

The method may further include, after the (S300) step: (S400) partially exposing the first dry film by using a photo mask to form a cured area and an uncured area; (S500) developing the second laminate of the (S400) step to remove a predetermined area of the first dry film; (S600) etching the second laminate of the (S500) step to form a circuit pattern and a plurality of second recognition marks on the metal foil such that the plurality of second recognition marks are formed in both ends of the metal foil; and (S700) of forming a third laminate by simultaneously removing the first and second dry films from the second laminate of the (S600) step.

The method may further include, after the (S700) step: forming one or a plurality of second holes and a plurality of third recognition marks in the second coverlay film continuously supplied from the second coverlay supply roller around which the second coverlay film is wound; and laminating the second coverlay film on a first surface of the third laminate.

The (S900) step may be performed by line-lamination using a pair of second heating rollers facing both surfaces of the third laminate, respectively.

The disclosure provides a flexible printed circuit board manufactured by the method described above.

### Advantageous Effects of Invention

According to the disclosure, a flexible printed circuit board is automatically and continuously manufactured through roll-to-roll throughout the entire process to reduce defects in handling, save manpower, shorten the time of the manufacturing process, control quality, and improve yield, thereby improving mass productivity and reducing cost.

### Brief Description of Drawings

FIGS. 1 to 8 are cross-sectional views showing each process of manufacturing a flexible printed circuit board according to an embodiment of the disclosure.

FIG. 9 is a schematic cross-sectional view of an apparatus used for manufacturing a flexible printed circuit board according to the disclosure.

FIG. 10 is a plan view schematically showing a second coverlay film for measuring MD and TD dimensional change rates.

**Description of Symbol**

10: First coverlay film, 11: First substrate,
12: First adhesive layer, 13a: First hole,
13b: First recognition mark; 20: Metal foil,
20a: First surface of metal foil, 20b: Second surface of metal foil,
21: Circuit pattern; 22: Second recognition mark,
30: First dry film, 30A: Curing area,
30B1, 30B2: uncured area, 31, 32: Removed area,
40: Second dry film, 50: Second coverlay film,
51: Second substrate, 52: Second adhesive layer,
53a: Second hole, 53b: Third recognition mark,
100: First laminate, 200A, 200B, 200C, 200D: Second laminate,
300: Third laminate, 400: Flexible printed circuit board

**Best Mode for Carrying out the Invention**

Hereinafter, the disclosure will be provided.

In the disclosure, in connection with the manufacturing of a double access-type flexible printed circuit board (FPCB) in which coverlay films are laminated on both surfaces of a metal foil on which a circuit pattern is formed, the coverlay film having a width wider than that of the metal foil and protruding farther than both sides of the metal foil is used, the coverlay film being disposed on one side of the metal foil. That is, the coverlay film has a non-overlapping area with the metal foil, that is, a dummy area. A recognition mark (e.g., an aligned hole) is formed in the dummy area of the coverlay film, and the recognition mark are exposed even after the metal foil is laminated on the coverlay film. The recognition mark thus exposed may be used as it is as a reference for alignment between the coverlay punched part and a metal circuit in an exposure process, even if a separate recognition mark is not formed on the metal foil. Therefore, unlike the related art, the disclosure can omit a process of forming a recognition mark (e.g., a recognition hole) for alignment, during exposure, on a metal foil in a laminate of a coverlay film and the metal foil by using a punching machine (e.g., a laser drill), before forming a circuit pattern. Because of this, the disclosure can improve production efficiency by simplifying the manufacturing process.

In addition, in the disclosure, when a hole (hereinafter referred to as a "first hole") for forming a circuit pattern in the coverlay film, the above-mentioned recognition mark is punched together. Accordingly, in the disclosure, no separate process for punching out a recognition mark needs to be performed, and thus production efficiency can be improved.

In the disclosure, the metal foil and the coverlay film are laminated by line contact pressing with a pair of heating rollers. As such, according to the disclosure, unlike the related art using a hot press, line contact pressure lamination is performed instead of surface contact pressure lamination. For this reason, the disclosure can significantly reduce the occurrence of voids between the interface between the metal foil and the coverlay film, thereby reducing the defect rate of the product and reducing the dimensional change rate of the product by shortening the laminating time.

In addition, as described above, the disclosure may laminate the metal foil and the coverlay film by using a pair of heating rollers, thereby bonding the continuously supplied metal foil and the coverlay film, while automatically and continuously transferring a laminate of the bonded metal foil and the coverlay to a subsequent process. Thus, according to the disclosure, unlike the related art, a flexible printed circuit board may be automatically and continuously manufactured through roll-to-roll (R2R) of the entire process, and thus manual work and intermediate processes can be omitted. Therefore, the disclosure not only facilitates quality control by preventing the occurrence of defects such as wrinkles and contamination or misalignment of products caused by the manual work, but also enables large-area flexible printed circuit boards.

Furthermore, according to the disclosure, a dry film is not only attached to the metal foil side surface of the coverlay film-metal foil laminate, but also attached to the coverlay film side surface. That is, according to the disclosure, unlike the related art, the dry film is attached instead of the carrier film to the coverlay film side of the laminate, there is no need to separately perform a process of attaching and detaching the carrier film. In addition, since the dry film is manufactured for the purpose of realizing a circuit, the adhesive layer of the dry film itself has excellent chemical resistance, unlike the adhesive layer of the carrier film. For this reason, the dry film on the coverlay film side (i.e., the lower dry film of the laminate) can prevent etchant from penetrating into a hole of the coverlay film during etching. Therefore, according to the disclosure, the circuit defect rate caused by penetration of the etchant is low, and thus the quality and productivity of the flexible printed circuit board can be improved. In addition, according to the disclosure, unlike the related art, the lower dry film may also be removed together without residue during the upper strip process of removing the upper dry film, so that the manufacturing process can be simplified and the production efficiency can be further improved.

In addition, according to the disclosure, the flexible printed circuit board is automatically and continuously manufactured through roll-to-roll throughout the entire process to reduce defects in handling, save manpower, shorten the time of the manufacturing process, control quality, improve yield, improve mass productivity and reduce cost.

According to an example, a method for manufacturing a flexible printed circuit board is a method for manufacturing a flexible printed circuit board by a roll-to-roll continuous manufacturing method and includes: (S100) forming one or a plurality of first holes and a plurality of first recognition marks in a first coverlay film continuously supplied from a first coverlay supply roller around which the first coverlay film is wound; (S200) forming a first laminate by laminating a metal foil continuously supplied from a metal foil supply roller around which the metal foil is wound on a first surface of the first coverlay film of the (S100) step; and (S300) forming a second laminate by laminating a first dry film and a second dry film continuously supplied from a first and second dry film supply roller on a first surface and a second surface of the first laminate, respectively, wherein the width of the first coverlay film is wider than that of the metal foil, and the plurality of first recognition marks of the (S100) step are formed in an area of the first coverlay film that does not overlap with the metal foil.

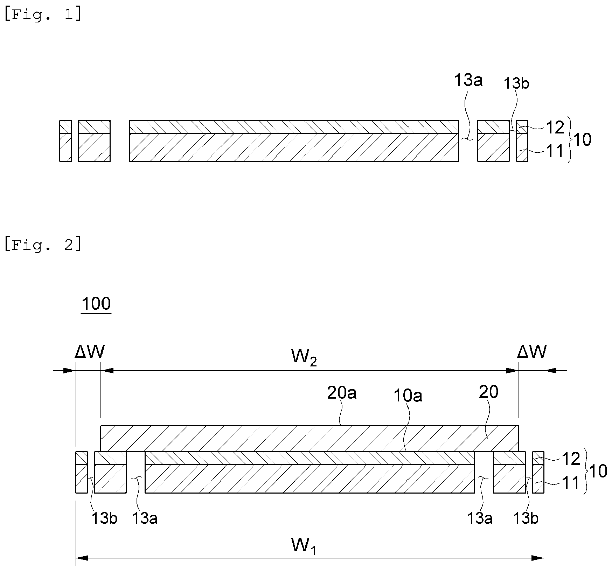

Hereinafter, each step of manufacturing a flexible printed circuit board according to the disclosure will be described with reference to attached FIGS. 1 to 8. However, in the method for manufacturing a flexible printed circuit board according to the disclosure, the following steps don't have to be performed in order, but each step in the process can be performed by modifying or selectively mixed according to design specifications.

(a) (S100) step: Punching first coverlay film

One or a plurality of first holes and a plurality of first recognition marks are formed in a first coverlay film 10 continuously supplied from a first coverlay supply roller around which the first coverlay film 10 is wound (see FIG. 1). At this time, the first coverlay film 10 in which the first hole and the first recognition mark are to be continuously formed is continuously and automatically transferred toward a subsequent process by transfer rollers.

In the (S100) step, while a circuit pattern hole (hereinafter referred to as a "first hole") 13a, such as a via hole (e.g. BVH), is formed by continuous punching as designed in the coverlay film 10 continuously supplied from a first coverlay supply roller, the first recognition mark 13b, which is a reference for performing alignment between a coverlay punched part and a metal circuit during an exposure process, is formed together by punching in an area that does not overlap with the metal foil.

According to an example, the first recognition mark 13b as a through-hole may be formed in an area of the first coverlay film that does not overlap with the metal foil. At this time, the shape of the through-hole is not particularly limited, and may be, for example, a circle, a polygon including a square, a triangle, etc., a cross, and the like.

The first coverlay film 10 used in the disclosure includes: a first substrate 11; and a first adhesive layer 12 disposed on one surface of the substrate.

Examples of the substrate 11 are not particularly limited as long as it is known in the art, and include polyimide (PI), polyethylene terephthalate (PET), and polyethylene naphthalate (PEN) .

The first coverlay film 10 has a long strip shape (e.g., a tape shape) in a progress direction (a machine direction (MD) and has a predetermined width in a direction (the transverse direction (TD)) crossing the progress direction.

The width ($W_1$) of the first coverlay film 10 according to the disclosure is wider than the width ($W_2$) of the metal foil. For example, the width ($W_1$) of the first coverlay film may be about 5 to 30 mm wider than the width ($W_2$) of the metal foil. That is, the width ($W_1$) of the first coverlay film may be wider than the width ($W_2$) of the metal foil by protruding about 2.5 mm to 15 mm farther from both sides of the metal foil. Therefore, the first coverlay film 10 of the disclosure may further have a dummy area on each side of the metal foil 20, compared to the metal foil 20, and in this case, the width [$\Delta W=(W_1-W_2)/2$] of each dummy area may range from about 2.5 to 15 mm. The dummy area ($\Delta W$) is an area that does not overlap with the metal foil and includes a plurality of first recognition marks 13b formed therein. At this time, the plurality of first recognition marks 13b may be formed symmetrically with each other. As described above, the first recognition mark 13b is exposed even after the metal foil is disposed on the first coverlay film. For this reason, even if a separate recognition mark is not formed on the metal foil, the first recognition mark 13b is used as a reference (i.e., an alignment hole) for aligning between a circuit pattern forming area using a dry film during exposure and the first hole 13a, which is a hole for forming a circuit pattern of the first coverlay film. Therefore, unlike the related art, the disclosure can omit a process of forming a separate recognition mark (e.g., a guide hole) in the metal foil, and accordingly, can improve production efficiency due to the simplification of the manufacturing process.

A device for punching the coverlay film is not particularly limited as long as it is generally known in the art, and includes, for example, a laser device, a punching machine (mold punching, rotary punching), and the like.

(b) (S200) step: formation of first laminate

Thereafter, in the (S100) step, a first laminate 100 is continuously formed by laminating the metal foil 20 continuously supplied from a metal foil supply roller on one surface of the first coverlay film 10 where the first hole 13a and the first recognition mark 13b are to be formed (see FIG. 2). The first laminate 100 continuously formed in the (S200) step is continuously and automatically transferred toward a subsequent process by transfer rollers.

The (S200) step is a process of laminating the metal foil 20 on a first surface (e.g., the upper surface) 10a of the first coverlay film 10 by using a laminating device to form the first laminate 100 including the metal foil 20 laminated on the first coverlay film 10.

Examples of the metal foil 20 usable in the disclosure are not particularly limited as long as it is a metal foil composed of a conductive material commonly used in the art. Non-limiting examples of the conductive material include chromium (Cr), nickel (Ni), zinc (Zn), molybdenum (Mo), tungsten (W), cobalt (Co), lead (Pb), silver (Ag), tantalum (Ta), copper (Cu), aluminum (Al), manganese (Mn), iron (Fe), titanium (Ti), tin (Sn), steel, zinc (Zn), vanadium (V), palladium (Pd) and the like, and these may be used alone or in the form of a mixture or alloy of two or more. According to an example, the metal foil 20 may be a copper foil.

The metal foil 20 has a long strip shape (e.g., a tape shape) in the machine direction (MD), and the size thereof may be adjusted according to the size of a final flexible printed circuit board.

The width (W2) of the metal foil 20 according to the disclosure is smaller than the width (W1) of the first coverlay film 10 described above. Accordingly, a partial area (i.e., a dummy area) of the first coverlay film 10 that does not overlap with the metal foil 20 is exposed from the first laminate 100, whereby the plurality of first recognition mark 13b formed in the dummy area is also exposed.

In addition, the thickness of the metal foil 20 is not particularly limited, and may be, for example, about 5 to 50 $\mu$m, specifically about 5 to 35 $\mu$m.

Examples of the laminating device usable in the disclosure are not particularly limited as long as it is known in the art, and include, for example, a heating roller, a hot press machine, and the like.

However, when using a heating roller, unlike the case of using a hot press machine, the first coverlay film 10 does not need to be separately cut into predetermined unit areas before the metal foil 20 and the first coverlay film 10 are laminated. Therefore, when laminating using the heating roller, the first coverlay film 10, which is continuously supplied while the first hole 13a and the first recognition mark 13b are formed thereon in the (S100) step, may be laminated on the first surface 20a of the metal foil 20 to be automatically and continuously transferred to a subsequent process, without being cut into predetermined unit areas. In addition, the laminate of the first coverlay film-metal foil is pressed and laminated using a line contact pressure when using the heating roller, so that a heating and pressing time is shortened to about 1 to 5 seconds. Therefore, unlike the related art using hot press, which is a surface contact press method, the disclosure can prevent dimensional change of a product due to the shortening of the heating and pressing time. In addition, since the pair of heating rollers continuously compress the interface between the first coverlay film and the metal foil, voids at the interface can be removed. Therefore, the occurrence of voids is suppressed and the defect rate of the flexible printed circuit board manufactured according to the disclosure can be reduced.

According to an example, in the (S200) step, the metal foil 20 is laminated on the first surface 10a of the first coverlay film 10 by using the pair of first heating rollers facing both surfaces of the first laminate 100, respectively. The first heating roller has an induction coil installed therein. When an alternating current is passed through the induction coil, lines of magnetic force are generated, and eddy currents induced by the lines of magnetic force flow on the surface of the roller, causing the roller itself to generate heat. The first heating roller has excellent thermal efficiency, has a semi-permanent lifespan, and has a uniform temperature distribution, thereby uniformly bonding the metal foil 20 and the first coverlay film 10 to each other.

The (S200) step may be performed for about 1 second to 3 minutes, specifically, 5 seconds to 3 minutes.

As described above, according to the disclosure, the first coverlay film 10 and the metal foil 20 are line-laminated to each other by using the pair of first heating rollers, thereby reducing not only the defect rate of a product but also as the dimensional change rate of the product.

(c) (S300) step: Formation of second laminate

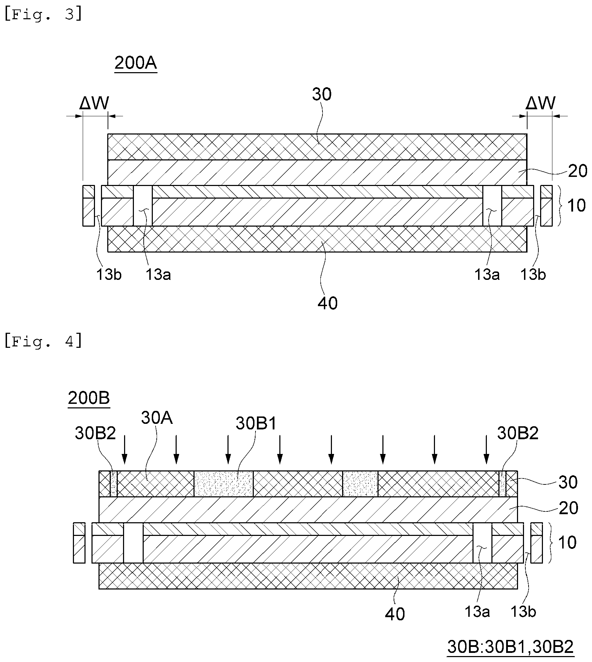

As shown in FIG. 3, a first dry film 30 and a second dry film 40 continuously supplied from a first and second dry film supply rollers, respectively are laminated on a first surface (e.g., the upper surface) and a second surface (e.g., the lower surface) of the first laminate 100, respectively, to form a second laminate 200A. Here, the first surface of the first laminate 100 is the surface 20a of the metal foil 20 in contact with the first dry film 30, and the second surface of the first laminate 100 is the surface 10b of the first coverlay film 10 in contact with the second dry film 40.

In the disclosure, not only the first dry film 30 is disposed on the first surface (e.g., the upper surface) of the first laminate 100 where the circuit pattern is to be implemented, but also the second dry film 40 is disposed on the second surface (e.g., the lower surface) of the first laminate 100. In this case, the first and second dry films 30 and 40 may be identical to or different from each other. However, in order to remove the first and second dry films 30 and 40 simultaneously, it is preferable that the same are identical to each other. Among the dry films 30 and 40, the first dry film 30 may include a photosensitive resist layer to implement a circuit pattern on the metal foil 20. In addition, the second dry film 40, like a carrier film, prevents an etching solution from penetrating into the first hole 13a and the first recognition mark 13b of the first coverlay film 10 during an etching process. In addition, the disclosure, the dry films 30 and 40 are disposed on both surfaces of the second laminate 200A, and accordingly, unlike the related art using a carrier film, the second dry film 40 may be exfoliated and removed together during the process of removing the first dry film 30 without having to perform a separate process of removing the carrier film, thereby simplifying the manufacturing process and thus improving production efficiency. In addition, whereas residues of the adhesive layer remain when the carrier film is exfoliated, the first and second dry films 30 and 40 of the disclosure can be removed without leaving residues of the adhesive layer when exfoliated.

The first and second dry films 30 and 40 usable in the disclosure are not particularly limited as long as they are generally known in the art. For example, the first and second dry films 30 and 40 may have a structure in which a photoresist layer and a protection layer (e.g., a polyester film) are sequentially stacked on a substrate (e.g., a polyester film).

The widths of the first and second dry films 30 and 40 may be preferably smaller than the width of the first coverlay film 10, and specifically may be the same as the width of the metal foil 20. Accordingly, as in the first laminate 100, the dummy area of the first coverlay film 10 that does not overlap with the first and second dry films 30 and 40 are exposed from the second laminate 200A. Therefore, the plurality of first recognition marks 13b formed in the dummy area are also exposed.

The first and second dry films 30 and 40 are continuously supplied from the first and second dry film supply rollers and are laminated on the first surface and second surface of the first laminate 100, respectively, the first and second dry films 30 and 40 being wound around the first and second dry film supply rollers, respectively. At this time, the pair of compression roller units disposed facing both surfaces of the first laminate 100, respectively, is used. That is, the first and second dry films 30 and 40 respectively supplied to the upper and lower parts of the first laminate 100 are simultaneously passed between the pair of compression roller units together with the first laminate 100 and then the first and second dry films 30 and 40 may be collectively pressed on both surfaces of the first laminate 100, respectively.

(d) (S400): Exposure

Thereafter, the first dry film 30 is exposed to light to form a cured area and an uncured area (see FIG. 4).

The (S400) step may include (S410) laminating a photo mask on the first dry film 30 of the second laminate 200A; and (S420) exposing the first dry film to light.

In the (S410) step, the second laminate 200A is aligned using an alignment recognition camera or the like with the photo mask (not shown) with reference to parts protruding from both sides of the second laminate 200A, that is, the first recognition marks 13b respectively present in the dummy areas (ΔW) on both sides of the first coverlay film 10.

A cured area 30A and an uncured area 30B are formed on the first dry film 30 through the exposure of the (S420) step. However, in the disclosure, a part 30B2 of the uncured regions 30B1 and 30B2 is formed at both ends of the first dry film. When the uncured region 30B2 is removed by development, the exposed area of the metal foil 20 is removed by etching and the second recognition mark 22 for alignment with the second coverlay film 50 is formed. According to an example, the second recognition mark 22 may be a through-hole. At this time, the shape of the through-hole is not particularly limited, and may be, for example, a circle, a polygon including a square, a triangle, etc., a cross, and the like.

The photo mask (not shown) contains a pattern corresponding to a circuit pattern designed on the metal foil, and incident light is blocked by the pattern so that a cured area 30A and an uncured area 30B1 and/or 30B2 are formed in each unit area of the first dry film 30. At this time, an unexposed part or the exposed part is removed by a developing solution later, depending on whether the photo mask is a positive-type photo mask or a negative-type photo mask.

The exposure method is not particularly limited as long as it is a contact-type method, a proximity-type method, a projection-type method, and the like, which is known in the art. The exposure may be performed using an excimer laser, far ultraviolet, ultraviolet, visible light, electron beams, X-rays or g-rays (wavelength of about 436 nm), i-rays (wavelength of about 365 nm), h-rays (wavelength of about 405 nm), or a mixed light thereof.

(e) (S500) step: Development

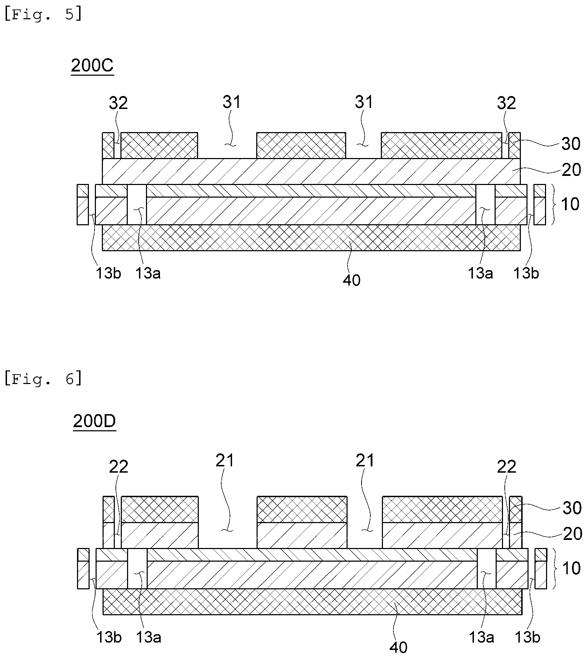

As shown in FIG. 5, the second laminate 200B in which the first dry film 30 is partially exposed is developed using an alkaline developing solution to remove uncured areas 30B1 and 30B2 (e.g., an unexposed part), thereby obtaining a second laminate 200C in which the metal foil 20 is partially exposed through the areas 31 and 32 removed from the first dry film. The exposed area of the metal foil 20 is removed through a subsequent etching process, so that the circuit pattern 21 and the plurality of second recognition marks 22 are formed on the metal foil 20.

Alkaline developing solution usable in the disclosure includes: aqueous solutions of quaternary ammonium hydroxides, such as tetramethyl ammonium hydroxide and tetraethyl ammonium hydroxide; amine-based aqueous solutions, such as ammonia, ethylamine, diethylamine, triethylamine; and the like, but are not limited thereto.

(f) (S600) step: Etching

As shown in FIG. 6, the second laminate 200C from which a predetermined area 31 or 32 of the first dry film 30 is removed is etched, thereby obtaining a second laminate 200D from which a partial area of the metal foil 20 is selectively removed.

In (S600) step, the areas of the metal foil exposed through the removal areas 31 and 32 of the first dry film in the second laminate 200C are selectively removed using an etchant. That is, a part of the metal foil 20 in the second laminate 200D corresponding to the removal areas 31 and 32 of the first dry film 30 are removed, and the remaining part of the meatal foil 20 is protected by the first dry film 30, so that the circuit pattern region 21 and the plurality of second recognition marks 22 are formed on the metal foil 20. At this time, the plurality of second recognition marks 22 are formed in both ends of the metal foil and are used as references for alignment with the second coverlay film 50. According to an example, the second recognition mark 22 may be formed as a through-hole and may be symmetrically formed in both ends of the metal foil 20.

The etchant usable in the disclosure is not particularly limited as long as it is generally used in the art, and includes: for example, a hydrogen peroxide/hydrochloric acid ($H_2O_2$/HCl) etchant; a copper etchant, such as cupric chloride ($CuCl_2$) and ferric chloride ($FeCl_3$); and an etchant such as CN-/$O_2$, NBSA (3-nitrobenzene sulfonic acid)/PEI (polyethylenimine), which may be used alone or in appropriate combination thereof.

(g) (S700) step: Exfoliation of first and second dry films

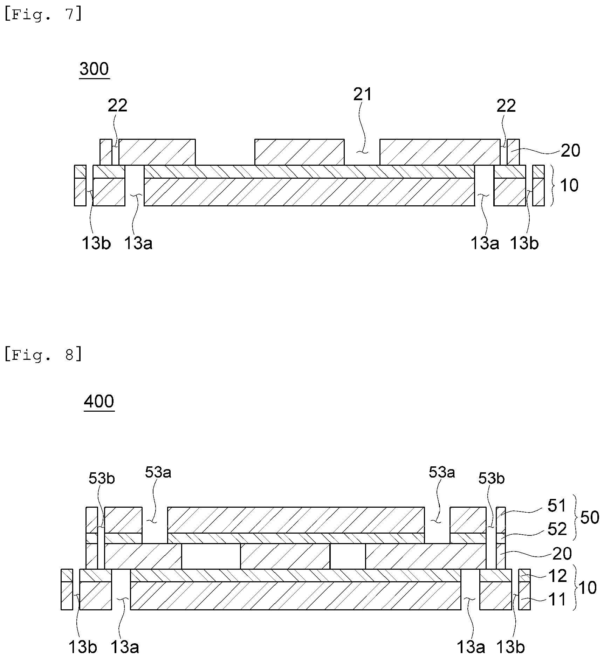

The first and second dry films 30 and 40 are simultaneously removed from the etched second laminate 200D to form a third laminate 300 (see FIG. 7).

The (S700) step is a process of simultaneously removing not only the first dry film 30 photopolymerized by irradiation of energy rays (e.g., UV beam) during the exposure process but also the second dry film 40 attached to the first coverlay film 10 by using a stripping solution. At this time, since no residue of the second dry film 40 is left on the surface of the first coverlay film 10, the defect rate of the flexible printed circuit board can be reduced.

The stripping solution usable in the disclosure is not particularly limited as long as it is generally used in the art for removing dry films, and includes, for example, strong bases, such as NaOH and KOH.

(h) (S800) step: Laminating second coverlay film

As shown in FIG. 8, the second coverlay film 50 continuously supplied from the second coverlay supply roller is laminated on the first surface (the upper surface) of the third laminate 300. Here, the first surface of the third laminate 300 is the surface of the metal foil 20 and is the surface opposite to the surface on which the first coverlay film 10 is laminated.

The (S800) step includes: (S810) forming one or a plurality of second holes 53a and a plurality of third recognition marks 53b in the second coverlay film 50 continuously supplied from the second coverlay supply roller around which the second coverlay film is wound; and (S820) laminating the second coverlay film 50 having the second holes 53a and the third recognition marks 53b on the first surface (e.g., the upper surface) of the third laminate 300.

The description of the second coverlay film and the punching device used in the (S810) step is the same as the description in the (S100) step which is the punching process of the first coverlay film, and thus will be omitted.

As in the first hole 13a of the first coverlay film 10, the second hole 53a of the second coverlay film 50 is a circuit pattern hole such as a via hole (e.g. BVH).

In addition, the third recognition marks 53b are formed in both ends of the second coverlay film 50, and are used as references for alignment with the second recognition mark 22 of the metal foil 20 in the third laminate 300 when the second coverlay film 50 is laminated on the third laminate 300. That is, the alignment between the second coverlay film 50 and the third laminate 300 is achieved by aligning the positions of the third recognition marks 53b of the second coverlay film and the positions of the plurality of second recognition marks 22 formed in both ends of the metal foil 20. According to an example, the third recognition marks 53b may be formed as a through-hole and be formed in both ends of the second coverlay film 50 corresponding to the positions of the second recognition marks 22. At this time, when the second recognition marks 22 are formed symmetrically in both ends of the metal foil 20, the third recognition marks 53b are also formed symmetrically with each other.

The width of the second coverlay film 50 may be smaller than that of the first coverlay film 10, and specifically equal to the width of the metal foil 20.

In the (S820) step, a pair of second heating rollers facing both surfaces of the third laminate 300, respectively, are used. Specifically, the second coverlay film 50 disposed on the second surface of the third laminate 300 and the third laminate 300 are passed between the pair of second heating rollers to obtain a flexible printed circuit board in which the first and second coverlay films 10 and 50 are respectively bonded to both sides of the metal foil 20.

As in the first heating rollers, the second heating rollers line-laminate the third laminate 300 and the second coverlay film 50, thereby reducing the defect rate of a product and the dimensional change rate of the product. The description of the second heating rollers is the same as that in the (S200) step which is the process of forming the first laminate and thus will be omitted.

The (S820) step may be performed for 1 second to 3 minutes (specifically, 5 seconds to 3 minutes) by using the pair of second heating rollers. The flexible printed circuit board 400 manufactured in the (S820) step may have an MD dimensional change rate and a TD dimensional change rate of -0.3 to 0.3%, respectively, according to Equations 1 and 2 below.

[Equations 1]

$$\text{MD dimensional change rate (\%)} = \frac{\frac{(A-B)_F-(A-B)_I}{(A-B)_I}+\frac{(C-D)_F-(C-D)_I}{(C-D)_I}}{2} \text{ X } 100$$

[Equations 2]

$$\text{TD dimensional change rate (\%)} = \frac{\frac{(A-C)_F-(A-C)_I}{(A-C)_I}+\frac{(B-D)_F-(B-D)_I}{(B-D)_I}}{2} \text{ X } 100$$

In [Equations 1] and [Equations 2],

$(A-B)_F$ is the distance between A-B of the second coverlay film in the final flexible printed circuit board,
$(A-B)_I$ is the distance between A-B of the second coverlay film before lamination on the third laminate,
$(C-D)_F$ is the distance between C-D of the second coverlay film in the final flexible printed circuit board,
$(C-D)_I$ is the distance between C-D of the second coverlay film before lamination on the third laminate,
$(A-C)_F$ is the distance between A-C of the second coverlay film in the final flexible printed circuit board,
$(A-C)_I$ is the distance between A-C of the second coverlay film before lamination on the third laminate,
$(B-D)_F$ is the distance between B-D of the second coverlay film in the final flexible printed circuit board, and
$(B-D)_I$ is the distance between B-D of the second coverlay film before lamination on the third laminate.

As described above, in the disclosure, the second coverlay film 50 and the flexible printed circuit board 300 are line-laminated using the pair of second heating rollers, thereby reducing the defect rate of a product and the dimensional change rate of the product.

(i) Selectively, protrusions from both sides of the flexible printed circuit board manufactured in the (S800) step, that is, both dummy areas of the first coverlay film 10 may be removed by cutting or the like.

As described above, the disclosure not only can automatically and continuously manufacture a flexible printed circuit board through roll-to-roll throughout the entire process, but also reduces defects in handling, shortens the time of the manufacturing process, controls quality, and improves yield, thereby improving mass productivity and reducing cost. In addition, the disclosure can lower the dimensional change rate of the final flexible printed circuit board.

Hereinafter, the disclosure will be described in more detail by providing Examples and Comparative Examples. However, the disclosure is not limited thereto.

**<Example 1>-Preparation of flexible printed circuit board**

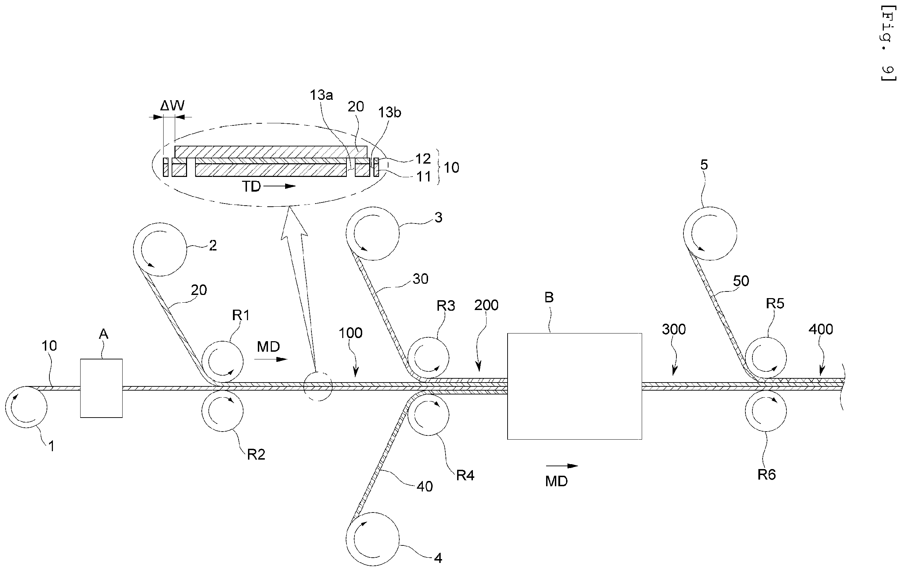

A flexible printed circuit board was continuously manufactured as follows by using the roll-to-roll apparatus shown in FIG. 9.

Specifically, a coverlay film 10 (Doosan Co., Ltd. DC-200, width: 520 mm) continuously supplied from a first coverlay supply roller 1 was punched using an excimer laser machine (A), to form a plurality of contact holes 13a (diameter: 1.7 mm) and a plurality of first recognition marks 13b (diameter: 2 mm) in the coverlay film 10. At this time, the first recognition marks 13b were formed symmetrically in both ends of the first coverlay film 10. Thereafter, a copper foil 20 (width: 500 mm) continuously supplied from a copper foil supply roller 2 was line-laminated using heating rollers R1 and R2 (roller temperature: about 110°C, line contact pressure: 5 kg/m$^2$, speed: 1 m/min) on the first coverlay film 10 in which the first holes and the first recognition marks are continuously formed, thereby forming a first laminate 100.

Thereafter, first and second dry films 30 and 40 (Asahi Chemical's AQ-3088, width: 500 mm) continuously supplied from first and second dry film supply rollers 3 and 4, respectively, were line-laminated using a pair of compression rollers R3 and R4 (roller temperature: 110°C, line contact pressure: 1.5 kg/m$^2$, speed: 1 m/min) on the upper and lower surfaces of the first laminate 100 continuously manufactured and supplied, thereby preparing a second laminate 200. Next, in a circuit pattern formation area (B), a photo mask was placed on the second laminate 200 through alignment with reference to the first recognition mark 13b of the first coverlay film 10, and then the first dry film 30 was partially exposed to light, followed by developing with an alkaline developing solution, etching, and then simultaneously removing the first and second dry films 30 and 40 with a stripping solution (NaOH), thereby obtaining a third laminate 300 in which a circuit pattern is formed on the metal foil 20. When the circuit pattern was formed, a plurality of second recognition marks 22 were formed together in both ends of the metal foil 20 in the third laminate 300. Thereafter, the second coverlay film 50 (Doosan Co., Ltd. DC-200, width: 500 mm) continuously supplied from the second coverlay supply roller 5 was placed on the automatically supplied third laminate 300 through alignment with reference to the second recognition mark 22, followed by line-laminating using a pair of heating rollers R5 and R6 (roller temperature: 110°C, line contact pressure: 5 kg/m$^2$, speed: 1 m/min) and then cutting and removing the dummy areas on both sides of the first coverlay film 10, thereby manufacturing the flexible printed circuit board 400.

**<Comparative Example 1>**

A flexible printed circuit board was manufactured in the same manner as in Example 1, except that a first coverlay film (width: 500 mm) having the same width as the metal foil was used instead of the first coverlay film having a width of 520 mm used in Example 1, and a guide hole corresponding to the through-hole of the first coverlay film was formed using an excimer laser machine in the metal foil part of the first laminate.

**<Comparative Example 2>**

A flexible printed circuit board was manufactured in the same manner as in Example 1, except that the second laminate was formed using a carrier film (INJ, KC-128A50) instead of the second dry film used in Example 1. At this time, the dry film was laminated on the copper foil of the first laminate and the carrier film was laminated on the first coverlay film, respectively.

**<Comparative Example 3>**

A flexible printed circuit board was manufactured in the same manner as in Example 1, except that a first coverlay film (width: 500 mm) having the same width as the metal foil was used instead of the first coverlay film having a width of 520 mm used in Example 1, a third recognition mark corresponding to the recognition mark of the first coverlay film was formed in the metal foil by punching a metal foil part of the first laminate with a rotary puncher, a carrier film (INJ, KC-128A50) instead of the second dry film was used to form the second laminate, the second laminate was cut into sheets of a predetermined unit before exposure, and the second coverlay film was laminated on the third laminate using a hot press machine instead of roll lamination.

**<Experimental Example 1>**

For the flexible printed circuit boards prepared in Example 1 and Comparative Examples 1 to 3, respectively, MD and TD dimensional change rates, productivity, and defect rates were measured as follows, and the results are shown in Table 1 below.

1-1. Dimensional change rate

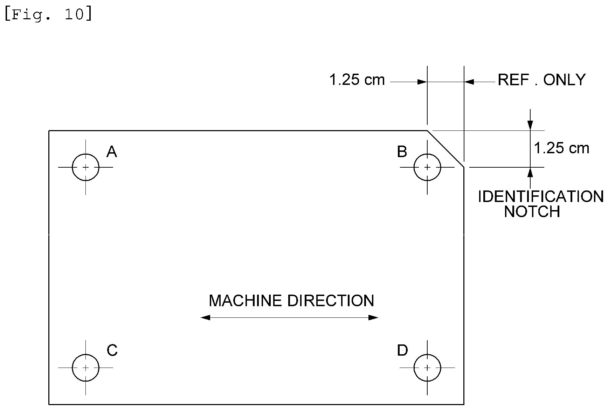

As shown in FIG. 10, each second coverlay film used when manufacturing the flexible printed circuit boards according to Example 1 and Comparative Examples 1 to 3 was punched at four corners to form recognition marks therein, and then the distances between the recognition marks (A-B, C-D, A-C, B-D) were measured respectively. Thereafter, a second coverlay film was laminated on a third laminate to manufacture a flexible printed circuit board, and then the distances between the recognition marks of the second coverlay film in the manufactured flexible printed circuit board were measured, respectively, to compare the distances between the recognition marks before and after each process. At this time, MD dimensional change rates and TD dimensional change rates were calculated according to Equations 1 and 2 below, respectively.

[Equations 1]

$$\text{MD dimensional change rate (\%)} = \frac{\frac{(A-B)_F-(A-B)_I}{(A-B)_I}+\frac{(C-D)_F-(C-D)_I}{(C-D)_I}}{2} \times 100$$

[Equations 2]

$$\text{TD dimensional change rate (\%)} = \frac{\frac{(A-C)_F-(A-C)_I}{(A-C)_I}+\frac{(B-D)_F-(B-D)_I}{(B-D)_I}}{2} \times 100$$

In [Equations 1] and [Equations 2],

$(A-B)_F$ is the distance between A-B of the second coverlay film in the final flexible printed circuit board,
$(A-B)_I$ is the distance between A-B of the second coverlay film before lamination on the third laminate,
$(C-D)_F$ is the distance between C-D of the second coverlay film in the final flexible printed circuit board,
$(C-D)_I$ is the distance between C-D of the second coverlay film before lamination on the third laminate,
$(A-C)_F$ is the distance between A-C of the second coverlay film in the final flexible printed circuit board,
$(A-C)_I$ is the distance between A-C of the second coverlay film before lamination on the third laminate,
$(B-D)_F$ is the distance between B-D of the second coverlay film in the final flexible printed circuit board, and
$(B-D)_I$ is the distance between B-D of the second coverlay film before lamination on the third laminate.

1-2. Productivity

In manufacturing the flexible printed circuit boards according to Example 1 and Comparative Examples 1 to 3, the productivity of the flexible printed circuit boards was evaluated in consideration of the presence or absence of the recognition mark in the metal foil through punching, the presence or absence of the attached second dry film, the presence or absence of the attached carrier film, and total manufacturing time. At this time, if the productivity is excellent, it is marked with "◎", if the productivity is good, it is marked with "○", if the productivity is poor, it is marked with "△", and if the productivity is very poor, it is marked with "x".

1-3. Presence or absence of defect in circuit pattern

The circuit pattern part of each of the final flexible printed circuit boards were photographed using an optical inspection device, and then the photographed image was observed with the naked eye. At this time, if there was no defect in the circuit pattern, it was marked with "x", and if there was a defect in the circuit pattern, it was marked with "○".

[Table 1]

| Process | | Example1 | Comparativ e example1 | Comparativ e example2 | Comparativ e example3 |
|---|---|---|---|---|---|
| Dimensional change rate (%) | M.D. | 0.018 | 0.030 | 0.054 | 0.310 |
| | T.D. | 0.005 | 0.025 | 0.030 | 0.171 |
| Productivity | | ◎ | ○ | △ | X |
| Presence or absence of guide hole though punching | | X | ○ | X | ○ |
| Presence or absence of attached first dry film | | X | ○ | ○ | ○ |
| Presence or absence of attached carrier film | | X | X | ○ | ○ |
| Presence or absence of defect in circuit pattern | | X | X | ○ | ○ |

**Claims**

1. A method for manufacturing a flexible printed circuit board by a roll-to-roll continuous manufacturing method, the method comprising:

   (S100) forming one or a plurality of first holes and a plurality of first recognition marks in a first coverlay film continuously supplied from a first coverlay supply roller around which the first coverlay film is wound;
   (S200) forming a first laminate by laminating a metal foil continuously supplied from a metal foil supply roller around which the metal foil is wound on a first surface of the first coverlay film of the (S100) step; and
   (S300) forming a second laminate by laminating a first dry film and a second dry film continuously supplied from a first and second dry film supply roller on a first surface and a second surface of the first laminate, respectively, wherein a width of the first coverlay film is wider than that of the metal foil, and the plurality of first recognition marks of the (S100) step are formed in an area of the first coverlay film that does not overlap with the metal foil.

2. The method of claim 1, wherein the method does not comprise, after the (S200) step and before the (S300) step, forming a recognition mark for alignment during exposure in the metal foil of the first laminate.

3. The method of claim 1, wherein the width of the first coverlay film is 5 to 30 mm wider than the width of the metal foil.

4. The method of claim 1, wherein the (S200) step comprises: line-laminating the first coverlay film on the metal foil by using a pair of first heating rollers facing both surfaces of the first laminate, respectively.

5. The method of claim 4, wherein the (S200) step is performed for 5 seconds to 3 minutes.

6. The method of claim 1, wherein the widths of the first dry film and the second dry film are smaller than the width of the first coverlay film.

7. The method of claim 1, further comprising, after the (S300) step:

   (S400) partially exposing the first dry film by using a photo mask to form a cured area and an uncured area;
   (S500) developing the second laminate of the (S400) step to remove a predetermined area of the first dry film;
   (S600) etching the second laminate of the (S500) step to form a circuit pattern and a plurality of second recognition marks on the metal foil, wherein the plurality of second recognition marks are formed in both ends of the metal foil; and
   (S700) forming a third laminate by simultaneously removing the first and second dry films from the second laminate of the (S600) step.

8. The method of claim 7, further comprising, after the (S700) step, laminating a second coverlay film on a first surface of the third laminate.

9. The method of claim 8, wherein the second coverlay film contains one or a plurality of second holes and a plurality of third recognition marks.

10. The method of claim 8, wherein the width of the second coverlay film is smaller than the width of the first coverlay film.

11. The method of claim 8, wherein the laminating of the second coverlay film and the third laminate is performed by line-lamination using a pair of second heating rollers facing both surfaces of the third laminate, respectively.

12. The method of claim 11, wherein the laminating of the second coverlay film is performed for 5 seconds to 3 minutes.

13. The method of claim 11, wherein the flexible printed circuit board has an MD dimensional change rate and a TD dimensional change rate of -0.3 to 0.3%, respectively, according to Equations 1 and 2 below,

[Equations 1]

$$\text{MD dimensional change rate (\%)} = \frac{\frac{(A-B)_F - (A-B)_I}{(A-B)_I} + \frac{(C-D)_F - (C-D)_I}{(C-D)_I}}{2} \times 100$$

, and

[Equations 2]

$$\text{TD dimensional change rate (\%)} = \frac{\frac{(A-C)_F - (A-C)_I}{(A-C)_I} + \frac{(B-D)_F - (B-D)_I}{(B-D)_I}}{2} \times 100$$

wherein in [Equations 1] and [Equations 2],

$(A-B)_F$ is the distance between A-B of the second coverlay film in the final flexible printed circuit board,
$(A-B)_I$ is the distance between A-B of the second coverlay film before lamination on the third laminate,
$(C-D)_F$ is the distance between C-D of the second coverlay film in the final flexible printed circuit board,
$(C-D)_I$ is the distance between C-D of the second coverlay film before lamination on the third laminate,
$(A-C)_F$ is the distance between A-C of the second coverlay film in the final flexible printed circuit board,
$(A-C)_I$ is the distance between A-C of the second coverlay film before lamination on the third laminate,
$(B-D)_F$ is the distance between B-D of the second coverlay film in the final flexible printed circuit board, and
$(B-D)_I$ is the distance between B-D of the second coverlay film before lamination on the third laminate.

14. A flexible printed circuit board manufactured by the method according to one of claims 1 to 13.

[Fig. 1]

13a  13b

12  } 10
11

[Fig. 2]

100

ΔW  W₂  ΔW

20a  10a  20

12  } 10
11

13b  13a  13a  13b

W₁

[Fig. 3]

200A

ΔW

30

ΔW

20

10

13b    13a

13a    13b

40

[Fig. 4]

200B

30B2    30A    30B1

30B2

30

20

10

40    13a    13b

30B:30B1,30B2

[Fig. 5]

200C

[Fig. 6]

200D

[Fig. 7]

<u>300</u>

[Fig. 8]

<u>400</u>

[Fig. 9]

[Fig. 10]

<table>
<tr><td colspan="2" align="center">**INTERNATIONAL SEARCH REPORT**</td><td colspan="2">International application No.<br>**PCT/KR2021/010948**</td></tr>
</table>

**A. CLASSIFICATION OF SUBJECT MATTER**

**H05K 3/00**(2006.01)i; **H05K 3/28**(2006.01)i; **H05K 1/02**(2006.01)i

According to International Patent Classification (IPC) or to both national classification and IPC

**B. FIELDS SEARCHED**

Minimum documentation searched (classification system followed by classification symbols)

H05K 3/00(2006.01); B29C 65/02(2006.01); B32B 15/08(2006.01); H05K 3/28(2006.01); H05K 3/46(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 롤투롤(roll to roll), 연성 인쇄회로기판(flexible printed circuit board), 커버레이 필름(coverlay film), 인식 마크(recognition mark), 금속 포일(metal foil), 드라이 필름(dry film)

**C. DOCUMENTS CONSIDERED TO BE RELEVANT**

| Category* | Citation of document, with indication, where appropriate, of the relevant passages | Relevant to claim No. |
|---|---|---|
| Y | JP 2007-005805 A (DK UIL CO., LTD.) 11 January 2007 (2007-01-11)<br> See paragraphs [0012]-[0021] and figures 1a-4. | 1-14 |
| Y | KR 10-2137278 B1 (KIM, Sang Bong et al.) 23 July 2020 (2020-07-23)<br> See paragraphs [0102]-[0105] and figure 9. | 1-14 |
| Y | KR 10-2016-0143971 A (YOUNG POONG ELECTRONICS CO., LTD.) 15 December 2016<br>(2016-12-15)<br> See paragraphs [0037] and [0050] and figures 2-3 and 5. | 1-14 |
| Y | JP 2011-131553 A (KANEKA CORP.) 07 July 2011 (2011-07-07)<br> See paragraphs [0018]-[0037] and figure 1. | 4-5,12-13 |
| Y | KR 10-0609871 B1 (BHFLEX CO., LTD.) 08 August 2006 (2006-08-08)<br> See paragraph [0015] and figures 1-2. | 11-13 |

☐ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **06 December 2021** | **07 December 2021** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**
Information on patent family members

International application No.

**PCT/KR2021/010948**

| Patent document cited in search report | | | Publication date (day/month/year) | Patent family member(s) | | | Publication date (day/month/year) |
|---|---|---|---|---|---|---|---|
| JP | 2007-005805 | A | 11 January 2007 | CN | 1886029 | A | 27 December 2006 |
| | | | | JP | 4218768 | B2 | 04 February 2009 |
| | | | | KR | 10-0666282 | B1 | 09 January 2007 |
| | | | | KR | 10-2006-0134475 | A | 28 December 2006 |
| | | | | TW | 200704317 | A | 16 January 2007 |
| | | | | TW | I307614 | B | 11 March 2009 |
| KR | 10-2137278 | B1 | 23 July 2020 | None | | | |
| KR | 10-2016-0143971 | A | 15 December 2016 | None | | | |
| JP | 2011-131553 | A | 07 July 2011 | None | | | |
| KR | 10-0609871 | B1 | 08 August 2006 | KR | 10-2006-0083296 | A | 20 July 2006 |

Form PCT/ISA/210 (patent family annex) (July 2019)